(19) Europäisches Patentamt
European Patent Office
Office européen des brevets

(11) EP 4 362 270 A1

(12) EUROPEAN PATENT APPLICATION

(43) Date of publication:
01.05.2024 Bulletin 2024/18

(21) Application number: 23188552.6

(22) Date of filing: 28.07.2023

(51) International Patent Classification (IPC):
$H02J\ 7/00^{(2006.01)}$

(52) Cooperative Patent Classification (CPC):
H02J 7/00714; H02J 7/00304; H02J 7/007182;
H02J 2207/20

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.10.2022 KR 20220138102

(71) Applicant: Samsung Electronics Co., Ltd.
Suwon-si, Gyeonggi-do 16677 (KR)

(72) Inventors:
• CHO, Daewoong
16677 Suwon-si (KR)

• YOON, Kyeseok
16677 Suwon-si (KR)
• KIM, Seunghoon
16677 Suwon-si (KR)
• YOO, Jeongdu
16677 Suwon-si (KR)
• LEE, Sungwoo
16677 Suwon-si (KR)
• HEO, Jungwook
16677 Suwon-si (KR)

(74) Representative: Marks & Clerk LLP
15 Fetter Lane
London EC4A 1BW (GB)

(54) BATTERY CHARGER INTEGRATED CIRCUIT FOR ADAPTIVELY LIMITING OVER- CURRENT, MOBILE DEVICE COMPRISING THE SAME AND OPERATION METHOD THEREOF

(57) A circuit includes: an overcurrent limiting (OCL) detector configured to detect whether a level of an inductor current reaches an OCL level and to generate an OCL detection voltage; a control loop circuit (1100) configured to generate a reset voltage ($V_{RST}$) by comparing a ramp voltage reflecting the level of the inductor current ($I_{IND}$) with an error voltage generated based on an operating condition that is out of a preset operating condition; an adaptive OCL controller (1300) configured to generate an OCL control current ($I_{OCL}$) by counting a number of pulses of the OCL detection voltage and a number of pulses of the reset voltage ($V_{RST}$); an oscillator (1400) configured to generate an oscillation voltage (Vosc) wherein a frequency of the oscillation voltage (Vosc) varies based on a magnitude of the OCL control current ($I_{OCL}$); and a switching transistor (1800) for switching the inductor current based on the oscillation voltage.

FIG. 2

EP 4 362 270 A1

## Description

BACKGROUND

1. Field

Embodiments of the present disclosure described herein relates to a semiconductor device, and more particularly, to a battery charger integrated circuit that adaptively limits an overcurrent, a mobile device including the same, and an operation method thereof.

2. Description of Related Art

Recently, various types of mobile devices for communication or information exchange have been spread. A mobile device uses a rechargeable battery as a power source in order to provide an advantage of mobility. In general, when a mobile device is connected to a charger (e.g., a Travel Adapter (TA)) that enables battery charging, it operates in a charging mode (or a buck mode) for battery charging. On the other hand, when external devices are connected through a port such as a USB terminal, the mobile device also supports On-The-Go (OTG) mode (or a boost mode) to provide power to external devices using an internal battery. To this end, a charger Integrated Circuit (IC) (hereinafter "a charger IC") for managing a charging mode and an OTG mode of a battery is used in a mobile device.

In a battery charger IC of a switching method that manages a charging current of a battery by switching an inductor current, an inductor current level limit is required to protect circuit elements. By sensing the level of the inductor current, an overcurrent limit (OCL) operation was applied. In this case, it can be implemented with a simple structure, but the amount of energy that can be transferred through the inductor is limited due to an OCL. In addition, there is a problem in that ripple of a large inductor current generated according to a switching operation occurs. Accordingly, there is a need for a battery charger IC capable of reducing a ripple of an inductor current in an OCL operation and increasing the amount of supplied energy.

SUMMARY

Embodiments of the present disclosure provide a charger IC, a mobile device, and an operating method thereof capable of reducing the ripple of an inductor current in an overcurrent limit (OCL) operation and increasing the amount of supplied energy.

According to an aspect of the present disclosure, a battery charger integrated circuit for charging a battery, includes: an overcurrent limiting detector configured to detect whether a level of an inductor current reaches an overcurrent limiting level and to generate an overcurrent limiting detection voltage; a control loop circuit configured to generate a reset voltage by comparing a ramp voltage reflecting the level of the inductor current with an error voltage generated based on an operating condition that is out of a preset operating condition; an adaptive overcurrent limiting controller configured to generate an overcurrent limiting control current by counting a number of pulses of the overcurrent limiting detection voltage and a number of pulses of the reset voltage; an oscillator configured to generate an oscillation voltage wherein a frequency of the oscillation voltage varies based on a magnitude of the overcurrent limit control current; and a switching transistor for switching the inductor current based on the oscillation voltage.

According to another aspect of the present disclosure, an electronic device includes: an inductor supplying a charging current supplied from a charging terminal to a battery and a load; switching transistors configured to switch the inductor current flowing through the inductor based on a duty voltage and configured to transfer the inductor current as a battery current for charging the battery or a load current supplied to the load; and a battery charger integrated circuit configured to monitor a change in the load current and varying a switching frequency of the inductor current. The battery charger integrated circuit is configured to increase the switching frequency by counting a number of times that a level of the inductor current reaches an overcurrent limit level.

According to another aspect of the present disclosure, a method performed by a battery charger integrated circuit, the method includes: detecting an increase in a load current; increasing a duty cycle of a duty voltage for switching an inductor current in response to detecting the increase in the load current; detecting whether a level of the inductor current reaches a predetermined overcurrent limit level; and increasing a switching frequency of the duty voltage based on a number of consecutively reaching the predetermined overcurrent limit level of the inductor current, which reaches a predetermined reference number of times.

At least some of the above and other features of the invention are set out in the claims.

BRIEF DESCRIPTION OF THE DRAWINGS

The above and other aspects, features, and advantages of certain embodiments of the present disclosure will be more apparent from the following description taken in conjunction with the accompanying drawings, in which:

FIG. 1 illustrates a mobile device including a battery charger Integrated Circuit (IC) according to an embodiment of the present disclosure;
FIG. 2 illustrates a configuration of a battery charger IC of the present disclosure;
FIG. 3 illustrates an example of the control loop circuit of FIG. 2;
FIG. 4 illustrates an overcurrent limit (OCL) detector of FIG. 2 as an example;

FIG. 5 illustrates each of the adaptive OCL controller and an oscillator of FIG. 2 in detail;

FIG. 6 illustrates an OCL Control Current (IOCL) adjusting operation of the adaptive OCL controller of FIG. 5 as an example;

FIG. 7 illustrates a switching frequency control process in the battery charger IC of the present disclosure;

FIG. 8 illustrates an operating method of the adaptive OCL controller of FIG. 5;

FIG. 9 illustrates a waveform diagram exemplarily showing the effect of the present disclosure; and

FIG. 10 illustrates a power system of a mobile device according to another embodiment of the present disclosure.

DETAILED DESCRIPTION

It is to be understood that both the foregoing general description and the following detailed description are by way of example only, and it is to be considered that an additional description of the claimed invention is provided. Reference signs are indicated in detail in preferred embodiments of the present disclosure, examples of which are indicated in the reference drawings. Wherever possible, the same reference numbers are used in the description and drawings to refer to the same or like parts.

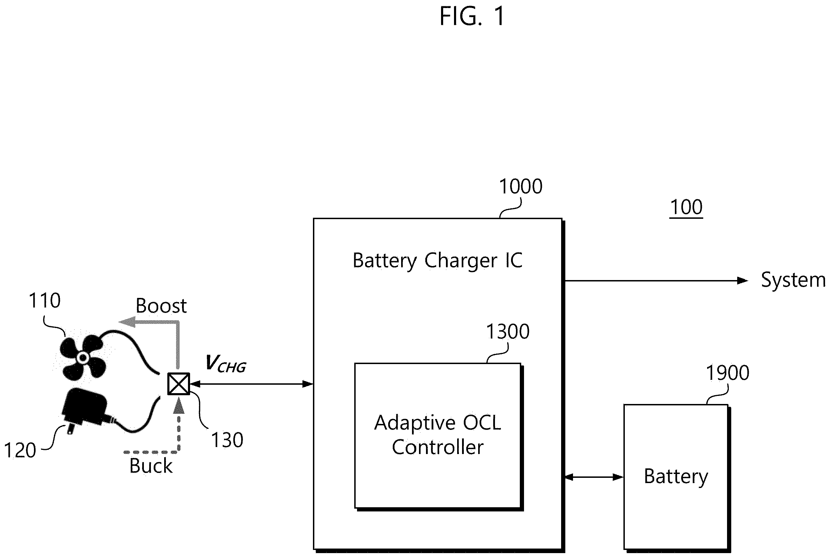

FIG. 1 is a block diagram showing a mobile device including a battery charger Integrated Circuit (IC) according to an embodiment of the present disclosure. In FIG. 1, a mobile device 100 according to the present disclosure may include a battery charger IC 1000 and a battery 1900 that adaptively perform overcurrent limiting.

The battery charger IC 1000 may operate in a buck mode or a boost mode according to a device connected to the charging terminal 130. For example, when a travel adapter 120 is connected to the charging terminal 130, the battery charger IC 1000 operates in a buck mode. That is, in the buck mode, the battery charger IC 1000 operates in a buck converter or charger mode in which the battery 1900 is charged by switching power provided through the travel adapter 120. On the other hand, when an On-The-Go (OTG) device 110 is connected to the charging terminal 130, the battery charger IC 1000 operates in a boost mode or OTG mode. That is, in the boost mode, the battery charger IC 1000 may switch power charged in the battery 1900 and provide the boosted voltage to the OTG device 110.

The battery charger IC 1000 may operate stably even in a charger mode or OTG mode under heavy load conditions. That is, the battery charger IC 1000 may stably supply load power to systems of the mobile device 100, such as an Application Processor (AP) memory, and storage, regardless of the operating mode. At this time, when the inductor current switched by the battery charger IC 1000 exceeds a saturation level, the battery charger IC 1000 may malfunction. Also, high inductor current may damage the battery charger IC 1000. Therefore, an overcurrent limit (OCL) operation is essential for the battery charger IC 1000 to prevent malfunction or damage.

The battery charger IC 1000 of the present disclosure includes an adaptive OCL controller 1300. The adaptive OCL controller 1300 may increase a switching frequency of the inductor current when the load current increases. At a fixed switching frequency, as in a related art, it is difficult to supply sufficient power to the required load. On the other hand, if the switching frequency of the inductor current is increased by the OCL controller 1300, maximum power transfer is possible within a range that does not violate the overcurrent limit. These advantages of the present disclosure will be explained in more detail through the drawings to be described later.

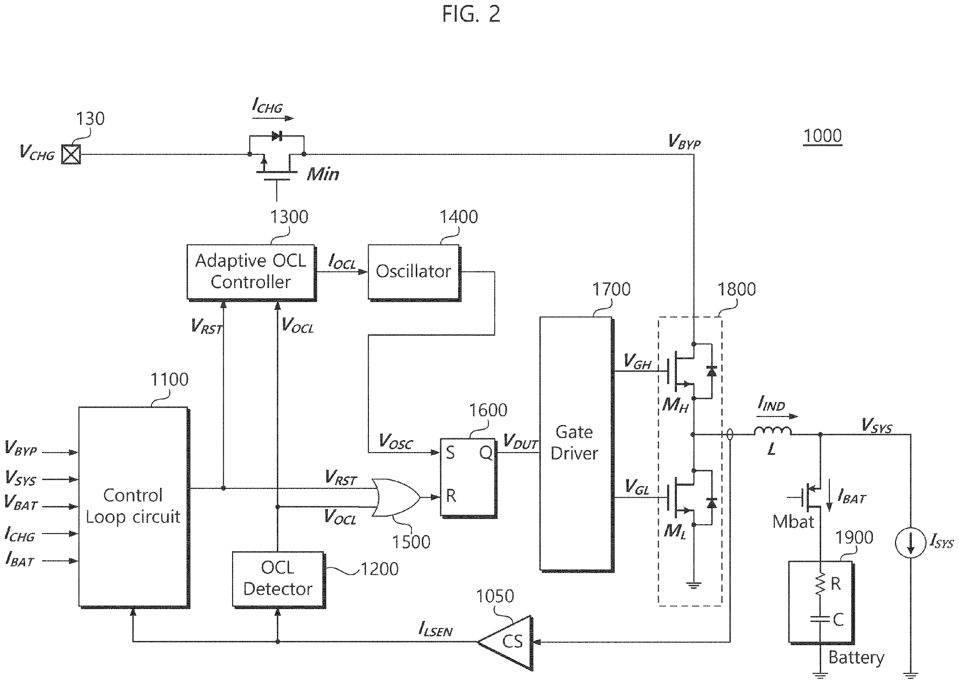

FIG. 2 is a block diagram showing the configuration of a battery charger IC of the present disclosure. In FIG. 2, the battery charger IC 1000 includes a control loop circuit 1100, an OCL detector 1200, an adaptive OCL controller 1300, an oscillator 1400, and an OR gate 1500, an SR latch 1600, a gate driver 1700, a switching transistor 1800, an inductor L, and a battery 1900.

The control loop circuit 1100 generates a reset voltage $V_{RST}$ for maintaining a preset charging condition or a voltage output condition. For example, in a charger mode or a buck mode, a case in which at least one level of preset charging conditions ($V_{BYP}$, $V_{SYS}$, $V_{BAT}$, $I_{CHG}$, $I_{BAT}$) exceeds a set range (or a predetermined range) may occur. At this time, the control loop circuit 1100 generates a reset voltage $V_{RST}$ as a control signal for reducing the inductor current $I_{IND}$.

Reset voltage $V_{RST}$ drives the switching transistor 1800 to reduce inductor current $I_{IND}$. That is, when the reset voltage $V_{RST}$ is provided at a high level, the duty voltage $V_{OUT}$ transitions to a low level, and as a result, the first switching transistor $M_H$ is turned off and the second switching transistor $M_L$ is turned on. Accordingly, a level of the inductor current $I_{IND}$ decreases.

In addition, in the OTG mode or the boost mode, when the level of the output voltage $V_{CHG}$ of the charging terminal 130 exceeds a set condition (or a predetermined condition), the control loop circuit 1100 generates the reset voltage $V_{RST}$ to reduce the inductor current $I_{IND}$. A specific configuration or function of the control loop circuit 1100 will be described in more detail through the drawings to be described later.

The OCL detector 1200 determines whether the inductor current reaches the OCL level based on the inductor detection current $I_{LSEN}$ sensed by the current sensor 1050. The OCL detector 1200 generates an OCL detection voltage $V_{OCL}$ based on the determination result. The OCL detection voltage $V_{OCL}$ is delivered to the adaptive OCL controller 1300 and the OR gate 1500, respectively.

The adaptive OCL controller 1300 generates an OCL control current $I_{OCL}$ for adjusting the switching frequency $f_{SW}$ of the inductor current $I_{IND}$ based on the reset voltage $V_{RST}$ and the OCL detection voltage $V_{OCL}$. For example, the adaptive OCL controller 1300 may increase the level of the OCL control current $I_{OCL}$ when the OCL detection voltage $V_{OCL}$ continuously occurs more than a reference number of times (select one (1) among above/below).

When the level of the OCL control current $I_{OCL}$ increases, the switching frequency fsw of the oscillation voltage Vosc generated by the oscillator 1400 increases. As the frequency of the oscillation voltage Vosc increases, the switching frequency fsw or a switching speed of the switching transistor 1800 increases. When the switching frequency fsw of the switching transistor 1800 increases, the ripple of the inductor current $I_{IND}$ delivered to the system becomes relatively small, and the average inductor current $I_{IND}$ increases. Thus, the amount of energy provided to the system is relatively increased.

On the other hand, the adaptive OCL controller 1300 reduces the OCL control current $I_{OCL}$ when the continuously occurring reset voltage $V_{RST}$ is greater than or equal to a reference number of times (select one (1) among above/below). When the level of the OCL control current $I_{OCL}$ decreases, the frequency of the oscillation voltage $V_{OSC}$ generated by the oscillator 1400 decreases. As the frequency of the oscillation voltage $V_{OSC}$ decreases, the switching frequency fsw or the switching speed of the switching transistor 1800 slows down. When the switching frequency fsw of the switching transistor 1800 is lowered, the ripple of the inductor current $I_{IND}$ delivered to the system becomes relatively large, and the average inductor current $I_{IND}$ decreases.

The oscillator 1400 generates an oscillation voltage Vosc having a variable frequency according to the level of the OCL control current $I_{OCL}$ provided by the adaptive OCL controller 1300. The oscillator 1400 may determine the rising slope of the node voltage $V_{SAW}$ through the OCL control current $I_{OCL}$. If the OCL control current $I_{OCL}$ is large, the node voltage $V_{SAW}$ increases rapidly.

Also, when the node voltage $V_{SAW}$ reaches the reference level, the oscillator 1400 generates a pulse-shaped oscillation voltage Vosc. Therefore, when the OCL control current $I_{OCL}$ is large, the generation frequency or frequency of the oscillation voltage Vosc increases. As a result, as the OCL control current $I_{OCL}$ increases, the switching frequency $f_{SW}$ of the duty voltage $V_{DUT}$ generated based on the oscillation voltage Vosc also increases. Then, the switching speed of the inductor current $I_{IND}$ is increased by the duty voltage $V_{DUT}$. The structure of the oscillator 1400 will be described in more detail through drawings to be described later.

The OR gate 1500 resets the SR latch 1600 when any one of the reset voltage $V_{RST}$ and the OCL detection voltage $V_{OCL}$ is activated. That is, the OR gate 1500 resets the SR latch 1600 when any one of the reset voltage $V_{RST}$ and the OCL detection voltage $V_{OCL}$ becomes high, and as a result, the duty voltage $V_{DUT}$ can be transitioned to a low level. When the duty voltage $V_{DUT}$ transitions to a low level, the first switching transistor $M_H$

of the switching transistor 1800 is turned off and the second switching transistor $M_L$ is turned on. Accordingly, the OR gate 1500 determines a falling point or duty cycle of the duty voltage $V_{DUT}$ to reduce the inductor current $I_{IND}$.

The SR latch 1600 generates a duty voltage $V_{DUT}$ for driving the gate driver 1700 or the switching transistor 1800. The duty voltage $V_{DUT}$ generates a duty voltage $V_{DUT}$. A duty cycle of the duty voltage $V_{DUT}$ is determined by the oscillation voltage $V_{OSC}$, the reset voltage $V_{RST}$, and the OCL detection voltage $V_{OCL}$. That is, the duty voltage $V_{DUT}$ transitions to a high level in synchronization with the oscillation voltage Vosc provided to the set input 'S' of the SR latch 1600. Also, the duty voltage $V_{DUT}$ transitions to a low level in synchronization with the reset voltage $V_{RST}$ or the OCL detection voltage $V_{OCL}$.

The gate driver 1700 generates gate control signals $V_{GH}$ and $V_{GL}$ for driving the switching transistor 1800 including power switches (power transistors), [DGJ1] based on the duty voltage $V_{DUT}$. The gate driver 1700 may generate gate control signals $V_{GH}$ and $V_{GL}$ having a sufficient level to drive the switching transistor 1800 operating at a relatively high voltage.

The switching transistor 1800 may include a first switching transistor $M_H$ and a second switching transistor $M_L$. The first switching transistor $M_H$ supplies the charging current $I_{CHG}$ to the inductor L to increase the inductor current $I_{IND}$ supplied to the system through the inductor L. On the other hand, the second switching transistor $M_L$ connects or blocks one end of the inductor L and the ground in order to reduce the inductor current $I_{IND}$ supplied to the system through the inductor L. The first switching transistor $M_H$ and the second switching transistor $M_L$ may be implemented as a power Metal-Oxide-Semiconductor Field-Effect Transistor (MOSFET) usable as a switching element.

The battery 1900 may be built into the mobile device 100. In one embodiment, the battery 1900 may be detachable from the mobile device 100. The battery 1900 may include one or a plurality of battery cells. A plurality of battery cells may be connected in series or parallel. The battery switch Mbat constituting an input terminal or an output terminal of the battery 1900 is shown as a PMOS transistor, but the present disclosure is not limited thereto. For example, it will be appreciated that the battery switch Mbat may be implemented with an NMOS transistor or other type of switch element.

As described above, the battery charger IC 1000 according to an embodiment of the present disclosure counts the number of times that the magnitude of the inductor current $I_{IND}$ reaches the OCL level to determine the switching frequency fsw of the inductor current $I_{IND}$. When the switching frequency fsw is fixed, the average value of the switched inductor current $I_{IND}$ cannot increase due to the OCL, making it difficult to supply sufficient power to the load. On the other hand, as the switching frequency fsw changes, the fluctuation of the switched inductor current $I_{IND}$ decreases, but the average value increases. Accordingly, it is possible to provide a relatively higher average value of inductor current $I_{IND}$, so that sufficient power required can be supplied to the load even in the presence of an OCL.

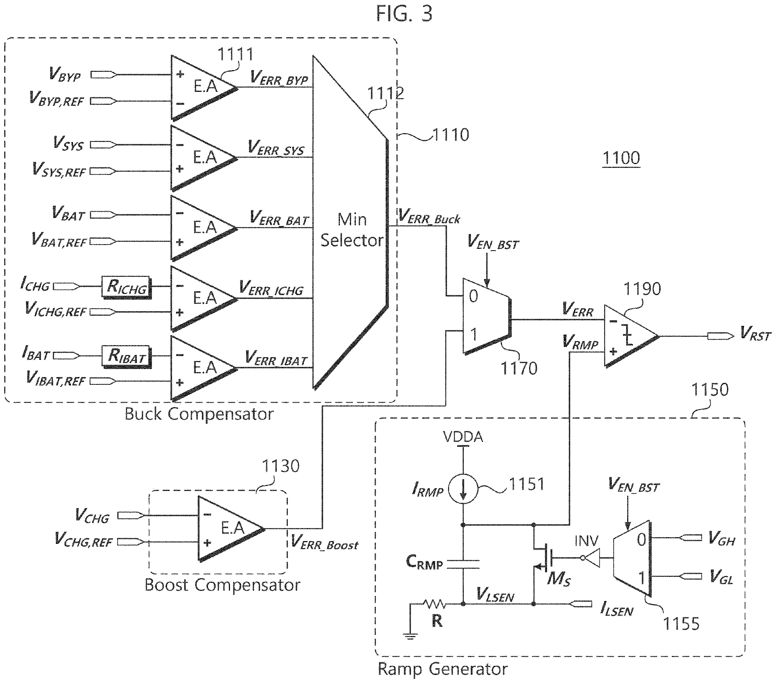

FIG. 3 is a circuit diagram showing an example of the control loop circuit of FIG. 2. In FIG. 3, the control loop circuit 1100 may include a buck compensator 1110, a boost compensator 1130, a ramp generator 1150, a multiplexer 1170, and a comparator 1190. The buck compensator 1110 and the boost compensator 1130 generate an error voltage $V_{ERR}$ when the preset charging conditions ($V_{BYP}$, $V_{SYS}$, $V_{BAT}$, $I_{CHG}$ and $I_{SAT}$) or output voltage $V_{CHG}$ conditions are exceeded in the buck mode or boost mode. On the other hand, the ramp generator 1150 generates the ramp voltage $V_{RMP}$ reflecting the sensing result $I_{LSEN}$ of the inductor current $I_{IND}$.

The buck compensator 1110 generates an error voltage $V_{ERR\_BUCK}$ by monitoring charging conditions ($V_{BYP}$, $V_{SYS}$, $V_{BAT}$, $I_{CHG}$ and $I_{BAT}$) when operating in a charging mode or a buck mode. For example, when the bypass voltage $V_{BYP}$ of the switching transistor 1800 rises beyond a reference value in the charging mode, this state is monitored by the error amplifier 1111 and an error voltage $V_{ERR\_BYP}$ is generated. Then, the output of the error amplifier 1111 is selected by the selector 1112 and transmitted to the multiplexer 1170. The multiplexer 1170 will select '0' input and pass it to the comparator 1190 in the charging mode. As such, in the charging mode, the buck compensator 1110 selects one of the charging conditions ($V_{BYP}$, $V_{SYS}$, $V_{BAT}$, $I_{CHG}$ and $I_{BAT}$) that exceeds or falls short of the reference value to generate the error voltage $V_{ERR}$, and comparator 1190 to trigger the generation of the reset voltage $V_{RST}$. When the reset voltage $V_{RST}$ is generated, the inductor current $I_{IND}$ is reduced by switching.

The boost compensator 1130 monitors the charging voltage $V_{CHG}$ generated at the charging terminal 130 in the boost mode. When the charging voltage $V_{CHG}$ rises excessively and exceeds the reference level $V_{CHG,REF}$, the error amplifier E.A of the boost compensator 1130 generates an error voltage $V_{ERR\_Boost}$. Then, the multiplexer 1170 selects the '1' input and passes it to the comparator 1190 in the boost mode. The comparator 1190 compares the error voltage $V_{ERR\_Boost}$ with the ramp voltage $V_{RMP}$ to generate the reset voltage $V_{RST}$. When the reset voltage $V_{RST}$ is generated, the inductor current $I_{IND}$ decreases due to switching, and the level of the charging voltage $V_{CHG}$ also decreases.

The ramp generator 1150 generates the ramp voltage $V_{RMP}$ for comparison with the error voltage $V_{ERR}$ in the comparator 1190. To generate the ramp voltage $V_{RMP}$, the ramp generator 1150 includes a ramp current source 1151, a capacitor $C_{RMP}$, a resistor R, a multiplexer 1155, an inverter INV, and a switch transistor Ms. The procedure for generating the ramp voltage $V_{RMP}$ is as follows.

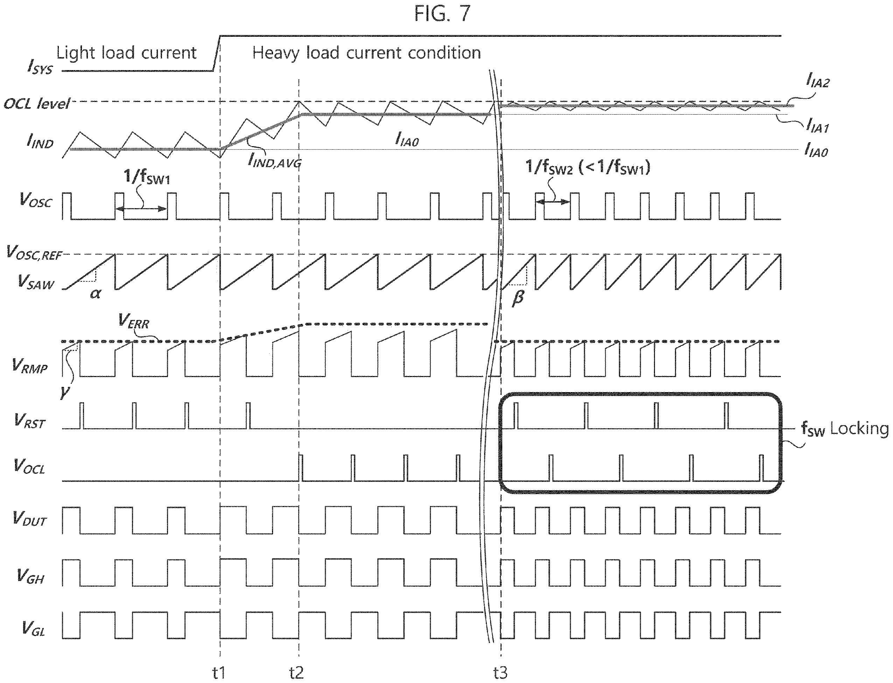

First, the sensing current $I_{LSEN}$ provided as a result of sensing the magnitude of the inductor current $I_{IND}$ is fed back and transmitted to the ramp generator 1150. Then, the sensing current $I_{LSEN}$ is converted into the sensing voltage $V_{LSEN}$ by the resistor R. Subsequently, when the ramp capacitor $C_{RMP}$ is charged by the ramp current $I_{RMP}$ supplied from the ramp current source 1151, the ramp voltage $V_{RMP}$ is obtained by adding the sensing voltage VLSEN and the voltage formed in the ramp capacitor $C_{RMP}$. In a period in which charges are charged by the ramp capacitor $C_{RMP}$, the ramp voltage $V_{RMP}$ has a ramp waveform rising with a predetermined slope. The multiplexer 1155 selects the gate control signal $V_{GL}$ for controlling the second switching transistor $M_L$ provided to the '1' input terminal in the boost mode. On the other hand, the multiplexer 1155 selects the gate control signal $V_{GH}$ that controls the first switching transistor $M_H$ provided to the '0' input terminal in the buck (or charge) mode. Currently, when the ramp generator 1150 is operating in the buck mode, the gate control signal $V_{GH}$ is selected and inverted by the inverter INV to turn on the switch transistor $M_S$. When the gate control signal $V_{GH}$ falls, the ramp voltage $V_{RMP}$ stops rising and is discharged. The waveform of the ramp voltage $V_{RMP}$ provided by the ramp generator 1150 will be described in detail with reference to FIG. 7 described below.

The multiplexer 1170 selects the error voltage $V_{ERR}$ according to the mode. In the boost mode, the multiplexer 1170 selects the error voltage $V_{ERR}$ from the boost compensator 1130 provided to the '1' input terminal and transfers it to the comparator 1190. On the other hand, in the buck (or charge) mode, the multiplexer 1170 selects the error voltage $V_{ERR}$ from the buck compensator 1110 provided to the '0' input terminal and transfers it to the comparator 1190.

The comparator 1190 compares the error voltage $V_{ERR}$ with the ramp voltage $V_{RMP}$ to generate the reset voltage $V_{RST}$. At a point in time when the ramp voltage $V_{RMP}$, which increases with the ramp waveform, becomes higher than the error voltage $V_{ERR}$, the comparator 1190 generates a pulse-shaped reset voltage $V_{RST}$. Accordingly, when the ramp voltage $V_{RMP}$ does not reach the error voltage $V_{ERR}$ within one cycle, there is a case in which the pulse of reset voltage VRST does not occur. For example, generation of the reset voltage $V_{RST}$ may be omitted in a period in which the inductor current $I_{IND}$ gradually increases. Instead, the drop of the duty voltage $V_{DUT}$ may be controlled by the OCL detection voltage $V_{OCL}$ generated according to the increase of the inductor current $I_{IND}$.

In the above, an example configuration of the control loop circuit 1100 of the present disclosure has been described. The ramp voltage $V_{RMP}$ and the error voltage $V_{ERR}$ are provided by the control loop circuit 1100. The control loop circuit 1100 generates the reset voltage $V_{RST}$ using the ramp voltage $V_{RMP}$ and the error voltage $V_{ERR}$. The reset voltage $V_{RST}$ is provided to the adaptive OCL controller 1300 of the present disclosure and is also used as a source for controlling the frequency of the oscillation voltage Vosc.

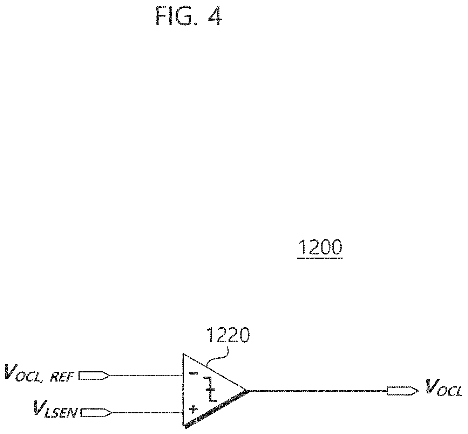

FIG. 4 is a circuit diagram showing the OCL detector of FIG. 2 as an example. In FIG. 4, the OCL detector 1200 generates an OCL detection voltage $V_{OCL}$ from a comparison result between a detection voltage $V_{LSEN}$ provided as a result of sensing the inductor current $I_{IND}$ and an OCL reference voltage $V_{OCL,REF}$.

Here, the sensing voltage $V_{LSEN}$ has a voltage level corresponding to the magnitude of the sensing current $I_{LSEN}$ generated from the sensing result of the inductor current $I_{IND}$. Accordingly, by selecting appropriate OCL reference voltages $V_{OCL,REF}$, the OCL detector 1200 may determine whether the magnitude of the inductor current $I_{IND}$ reaches the OCL level.

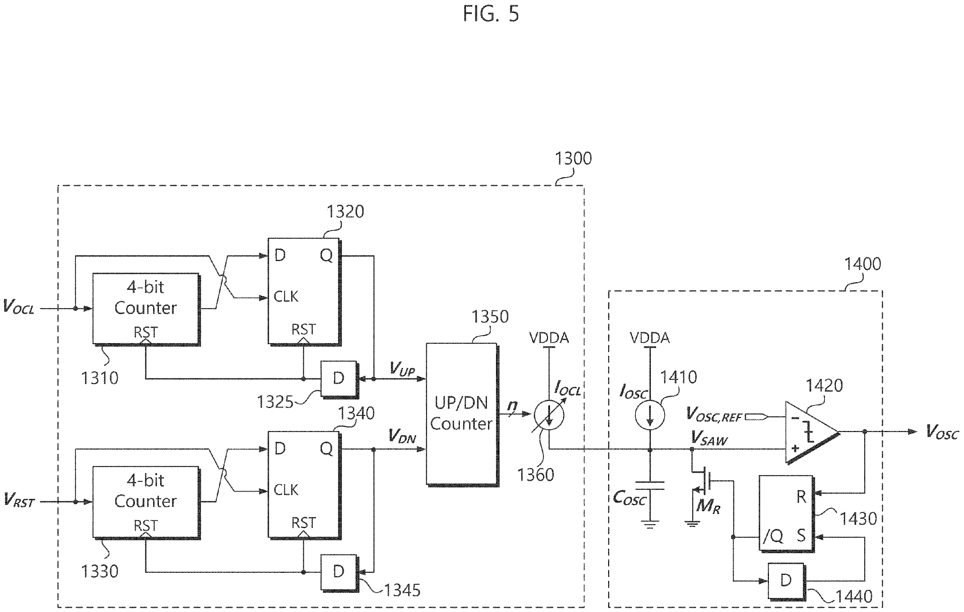

FIG. 5 illustrates each of the adaptive OCL controller and oscillator of FIG. 2 in detail. In FIG. 5, the adaptive OCL controller 1300 includes 4-bit counters 1310 and 1330, D-flip-flops 1320 and 1340, delays 1325 and 1345, and an up-and-down counter 1350, and a variable current source 1360. The oscillator 1400 may include an oscillation current source 1410, a comparator 1420, an SR latch 1430, a delay 1440, a discharge switch $M_R$, and an oscillation capacitor Cose.

The adaptive OCL controller 1300 increases the size of the OCL control current $I_{OCL}$ of the variable current source 1360 when the number of consecutive occurrences of the OCL detection voltage $V_{OCL}$ exceeds the reference number. The adaptive OCL controller 1300 reduces the size of the OCL control current $I_{OCL}$ of the variable current source 1360 when the number of consecutive occurrences of the reset voltage $V_{RST}$ exceeds the reference number.

To this end, the 4-bit counter 1310 may count the number of consecutive occurrences of the OCL detection voltage $V_{OCL}$. When the OCL detection voltage $V_{OCL}$ continuously occurs 16 times, the 4-bit counter 1310 transitions the data input terminal 'D' of the D flip-flop 1320 to a high level. Then, the data output terminal 'Q' of the D flip-flop 1320 is output at a high level, and the up voltage $V_{UP}$ is provided at a high level to count up the up-and-down counter 1350. Subsequently, the 4-bit counter 1310 and the D flip-flop 1320 are reset by the delay 1325. Here, the 4-bit counter 1310 may be modified into various bit sizes as needed. For example, if the 4-bit counter 1310 is replaced with a 3-bit counter, the up-and-down counter 1350 will be counted up when the OCL detection voltage $V_{OCL}$ occurs 8 times consecutively.

Also, the 4-bit counter 1330 may count the number of consecutive occurrences of the reset voltage $V_{RST}$. When the reset voltage $V_{RST}$ occurs 16 times consecutively, the 4-bit counter 1330 transitions the data input terminal 'D' of the D flip-flop 1340 to a high level. Then, the data output terminal 'Q' of the D flip-flop 1340 is output at a high level, and the up-and-down counter 1350 is counted down by the down voltage $V_{DN}$ of the high level. Subsequently, the 4-bit counter 1330 and the D flip-flop 1340 are reset by the delay 1345. Here, the 4-bit counter 1330 may also be changed to the same bit size as the 4-bit counter 1310.

The up-and-down counter 1350 counts up or down a predetermined bit value based on the up voltage $V_{UP}$ and the down voltage $V_{DN}$. The size of the OCL control current $I_{OCL}$ generated by the variable current source 1360 may be increased or decreased according to the count value 'n' of the up-and-down counter 1350. As a result, when pulses of the OCL detection voltage $V_{OCL}$ are continuously generated 16 times, the magnitude of the OCL control current $I_{OCL}$ increases. On the other hand, when the reset voltage $V_{RST}$ is continuously generated 16 times, the size of the OCL control current $I_{OCL}$ decreases.

The oscillator 1400 generates an oscillation voltage Vosc. A frequency of the oscillation voltage Vosc varies based on the magnitude of the OCL control current $I_{OCL}$. The oscillation current source 1410 provides an oscillation current lose for charging the oscillation capacitor Cose. As the oscillation capacitor Cosc is charged by the oscillation current losc, the node voltage $V_{SAW}$ formed across the oscillation capacitor Cosc is generated as a ramp waveform or a sawtooth waveform with a constant slope.

When the node voltage $V_{SAW}$ rises and reaches the oscillation reference voltage $V_{OSC,REF}$, the oscillation voltage Vosc is generated by the comparator 1420. The oscillation voltage Vosc is formed as a pulse voltage by the SR latch 1430, the delay 1440, and the discharge switch $M_R$. That is, when the oscillation voltage Vosc is output to a high level, the reset input terminal of the SR latch 1430 is set to a high level, and the inverted output terminal '/Q' also transitions to a high level. Then, the discharge switch $M_R$ is turned on and the node voltage VSAW formed across both ends of the oscillation capacitor Cosc is lowered to the ground level by discharging. The delay 1440 delays the inverting output terminal '/Q' to transition the SR latch 1430 to the set state. Then, the discharge switch $M_R$ is turned off again, and the node voltage $V_{SAW}$ starts to rise.

The switching frequency fsw of the inductor current $I_{IND}$ can be varied by the adaptive OCL controller 1300 and the oscillator 1400 of the present disclosure. Through the adjustment of the switching frequency $f_{SW}$, it is possible to supply a sufficient amount of energy to the load despite the limitation of the OCL level. Therefore, it is possible to provide a load current supply capability that cannot be achieved only by adjusting the duty cycle of the duty voltage $V_{DUT}$ driving the switching transistors 1800 (see FIG. 2) through the adaptive OCL controller 1300 and the oscillator 1400.

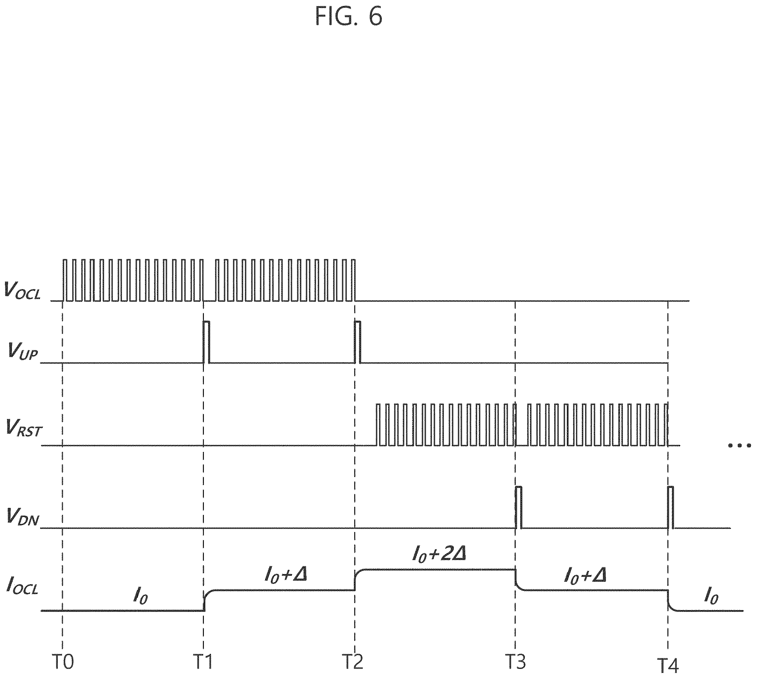

FIG. 6 is a timing diagram illustrating an OCL control current $I_{OCL}$ adjusting operation of the adaptive OCL controller of FIG. 5 as an example. In FIG. 6, the adaptive OCL controller 1300 may increase or decrease the OCL control current $I_{OCL}$ according to the number of consecutive occurrences of the OCL detection voltage $V_{OCL}$ or the reset voltage $V_{RST}$.

At time T0, as the level of the inductor current $I_{IND}$ increases to reach the OCL level, the OCL detection voltage $V_{OCL}$ starts to be generated. However, the count of the 4-bit counter 1310 of the adaptive OCL controller 1300 has only started, and the value of the up-and-down counter 1350 has not changed. Accordingly, the OCL control current $I_{OCL}$ generated by the variable current source 1360 maintains the initial value '$I_0$'. The OCL detection voltage $V_{OCL}$ continuously occurs 16 times until the time point T1.

At time T1, the count value of the 4-bit counter 1310 reaches '1111' according to 16 consecutive occurrences of the OCL detection voltage $V_{OCL}$ from time T0. Then, a pulse of the up voltage $V_{UP}$ is generated by the first D flip-flop 1320. Synchronized with the generation of the up voltage $V_{UP}$, the up-and-down counter 1350 counts up. According to the count-up of the up-and-down counter 1350, the OCL control current $I_{OCL}$ generated from the variable current source 1360 is generated with a size increased by a predetermined step '$\Delta$' from the initial value '$I_0$'.

At time T2, the count value of the 4-bit counter 1310 is counted up from '0000' to '1111' as the OCL detection voltage $V_{OCL}$ additionally occurs continuously 16 times from time T1 to time T2. Then, a pulse of the second up voltage $V_{UP}$ is generated by the first D flip-flop 1320. Synchronized with the generation of the up voltage $V_{UP}$, the up-and-down counter 1350 is counted up again. As the up-and-down counter 1350 counts up, the OCL control current $I_{OCL}$ generated from the variable current source 1360 increases to '$I_0+2\Delta$'.

From time T2 to time T3, as the reset voltage $V_{RST}$ occurs 16 times in succession, the count value of the 4-bit counter 1330 counts up from '0000' to '1111'. Then, the first down voltage $V_{DN}$ pulse is generated by the D flip-flop 1340. Synchronized with the occurrence of the first down voltage $V_{DN}$, the up-and-down counter 1350 counts down from the previous count value. As the up-and-down counter 1350 counts down, the magnitude of the OCL control current $I_{OCL}$ generated from the variable current source 1360 decreases to '$I_0+\Delta$'.

From time T3 to time T4, as the reset voltage $V_{RST}$ occurs again 16 times in succession, the count value of the 4-bit counter 1330 counts up from '0000' to '1111'. Then, a second down voltage $V_{DN}$ pulse is generated by the D flip-flop 1340 at the time T4. Synchronized with the generation of the second down voltage $V_{DN}$, the up-and-down counter 1350 counts down from the previous count value. As the up-and-down counter 1350 counts down, the magnitude of the OCL control current $I_{OCL}$ generated from the variable current source 1360 decreases to '$I_0$'.

In the above descriptions, the method of generating the OCL control current $I_{OCL}$ of the adaptive OCL controller 1300 has been described as an example. The adaptive OCL controller 1300 generates an OCL control current $I_{OCL}$ having a variable level based on the number of consecutive occurrences of the OCL detection voltage $V_{OCL}$ or the reset voltage $V_{RST}$. The frequency of the oscillation voltage Vosc or the switching frequency fsw may be adjusted according to the increase or decrease of the OCL control current $I_{OCL}$.

FIG. 7 illustrates a switching frequency control process in the battery charger IC of the present disclosure. In FIG. 7, the frequency of the oscillation voltage Vosc increases when the load current $I_{SYS}$ increases so that more power delivery to the system is required.

Before time t1, the battery charger IC 1000 is in a light load current condition. In addition, the load current $I_{SYS}$ required by the system of the mobile device 100 rises at the time point t1. That is, the battery charger IC 1000 is in a heavy load current condition after time t1.

Under light load current conditions, the magnitude of the inductor current $I_{IND}$ will not reach the OCL level even though there is ripple due to switching. At this time, although ripples exist in the inductor current IIND due to switching, the average inductor current $I_{IND,AVG}$ maintains a low state '$I_{IA0}$'. Accordingly, the reset voltage $V_{RST}$ of the control loop circuit 1100 is generated according to a comparison result between the error voltage $V_{ERR}$ and the ramp voltage $V_{RMP}$. That is, whenever the ramp voltage $V_{RMP}$ reaches the error voltage $V_{ERR}$, a reset voltage $V_{RST}$ pulse is generated.

The number of pulses of the reset voltage $V_{RST}$ may be accumulated and counted by the adaptive OCL controller 1300. Also, since there is no increase or decrease in the OCL control current $I_{OCL}$ before the time t1, the slope of the node voltage $V_{SAW}$ of the oscillator 1400 will maintain the '$\alpha$' value. The slope of the node voltage $V_{SAW}$ '$\alpha$' may be expressed by Equation 1 below.

[Equation 1]

Here, 'Iosc' represents the magnitude of the oscillation current that sets the

$$\alpha = \frac{}{C_{OSC}}$$

Here, '$I_{OSC}$' re|

basic slope, and 'Cose' represents the capacity of the oscillation capacitor for charging the current (see FIG. 5). In this state, the frequency of the oscillation voltage $V_{OSC}$ generated by the oscillator 1400 corresponds to the first switching frequency $f_{SW1}$.

At the time t1, the load current $I_{SYS}$ required by the system increases. As a result, when more power delivery to the load is required, the magnitude of the inductor current $I_{IND}$ increases and reaches to the OCL level. Then, the error voltage $V_{ERR}$ in the control loop circuit 1100 increases. The reset voltage $V_{RST}$ of the control loop circuit 1100 is generated according to a comparison result between the error voltage $V_{ERR}$ and the ramp voltage $V_{RMP}$. Therefore, as the error voltage $V_{ERR}$ becomes higher than the ramp voltage VRMP, the reset voltage VRST cannot be generated.

Instead, an OCL detection voltage $V_{OCL}$ pulse generated when the magnitude of the inductor current $I_{IND}$ reaches the OCL level in the OCL detector 1200 is generated. The OCL detection voltage $V_{OCL}$ pulse starts to occur at time t2. The number of continuously occurring OCL detection voltage $V_{OCL}$ pulses may be accumulated and counted by the adaptive OCL controller 1300. The number of OCL detection voltage $V_{OCL}$ pulses has not yet reached the count value that increases the OCL control current $I_{OCL}$. Accordingly, the slope of the node voltage $V_{SAW}$ for generating the sawtooth wave of the oscillator 1400 will maintain the 'α' value. In this state, the frequency of the oscillation voltage $V_{OSC}$ generated by the oscillator 1400 may still maintain the first switching frequency 'fSW1'. However, the number of counted OCL detection voltage $V_{OCL}$ pulses gradually increases, and a count value that increases the OCL control current $I_{OCL}$ will be reached.

After the time point t3, waveforms after the number of OCL detection voltage $V_{OCL}$ pulses reach a count value (e.g., 16) for increasing the OCL control current $I_{OCL}$ are shown. When the number of OCL detection voltage $V_{OCL}$ pulses reaches the count value (e.g., 16) that increases the OCL control current $I_{OCL}$, the slope of the node voltage $V_{SAW}$ for generating the sawtooth wave of the oscillator 1400 is 'β (>α)'. The slope of the node voltage $V_{SAW}$ 'β' may be expressed by Equation 2 below.

[Equation 2]

Here, 'Iosc' represents the size of the oscillation current that sets the basic slope,

$$\beta = \frac{}{C_{OSC}}$$

'Cosc' represents the capacity of the oscillation capacitor for charging the current, and '$I_{OCL}$' represents the size of the OCL control current (see FIG. 5). The frequency of the oscillation voltage $V_{OSC}$ generated by the oscillator 1400 increases to the second switching frequency '$f_{SW2}$' as the slope of the node voltage $V_{SAW}$ increases. And, as the second switching frequency '$f_{SW2}$' increases, the error voltage $V_{ERR}$ decreases again. Generation of the reset voltage $V_{RST}$ starts again by the lowered error voltage $V_{ERR}$.

In addition, the OCL detection voltage $V_{OCL}$ pulse by the OCL detector 1200 is also generated by the increase of the switching frequency and the increased average inductor current '$I_{IA2}$'. That is, the OCL detection voltage $V_{OCL}$ pulse generated when the inductor current $I_{IND}$ reaches the OCL level is alternately generated with the reset voltage $V_{RST}$ pulse. In this case, the number of counts of each of the reset voltage $V_{RST}$ and the OCL detection voltage $V_{OCL}$ in the adaptive OCL controller 1300 cannot reach a level at which the OCL control current $I_{OCL}$ is varied. That is, the frequency of the oscillation voltage $V_{OSC}$ generated by the oscillator 1400 is locked to the switching frequency '$f_{SW2}$' formed at the time t3.

As the switching frequency '$f_{SW2}$' is fixed at a higher value, the size of ripple due to switching of the inductor current $I_{IND}$ decreases. In addition, the level of the average inductor current '$I_{IA2}$' is also increased than before the time point t1 to approach the overcurrent limit level. This may indicate that more power can be delivered by increasing the amount of current delivered to the system or load.

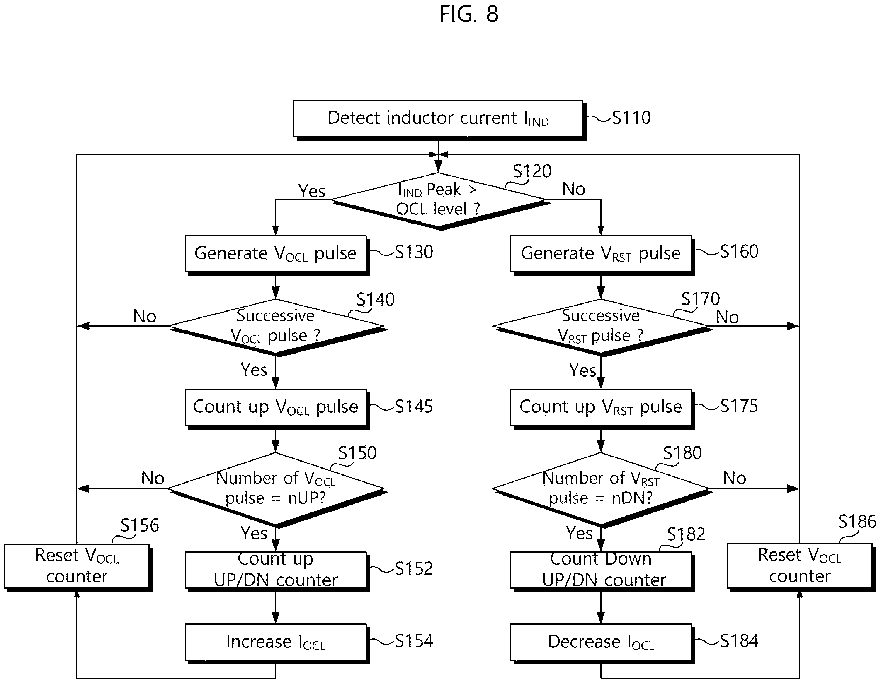

FIG. 8 illustrates an operating method of the adaptive OCL controller of FIG. 5. In FIG. 8, the adaptive OCL controller 1300 generates an OCL control current $I_{OCL}$ in response to a reset voltage $V_{RST}$ from the control loop circuit 1100 and an OCL detection voltage $V_{OCL}$ from the OCL detector 1200. Then, the oscillator 1400 may generate an oscillation voltage Vosc having a switching frequency that varies based on the OCL control current $I_{OCL}$.

In operation S110, the OCL detector 1200 senses the inductor current IIND. Detection of the magnitude of the inductor current $I_{IND}$ by the OCL detector 1200 may be performed using separate devices such as, for example, the current sensor 1050 (see FIG. 2).

In operation S120, an operation branch occurs according to a comparison result between the magnitude of the detected inductor current $I_{IND}$ peak and the OCL level. If the magnitude of the inductor current $I_{IND}$ peak is greater than the OCL level ('Yes' direction), the procedure moves to operation S130. On the other hand, if the magnitude of the detected inductor current IIND peak is not greater than the OCL level ('No' direction), the procedure moves to operation S160.

In operation S130, when the peak level of the sensed inductor current IIND is greater than the OCL level, the OCL detector 1200 generates an OCL detection voltage $V_{OCL}$ pulse.

In operation S140, it is checked whether OCL detection voltage $V_{OCL}$ pulses are continuously generated. If OCL detection voltage $V_{OCL}$ pulses continuously occur ('Yes' direction), the process moves to operation S145. On the other hand, when OCL detection voltage $V_{OCL}$ pulses are not continuously generated ('No' direction), the procedure returns to operation S120.

In operation S145, the number of consecutive OCL detection voltage VOCL pulses is counted. For example, a 4-bit counter may be used as an element for counting the number of consecutive OCL detection voltage $V_{OCL}$ pulses.

In operation S150, it is checked whether the number of consecutive OCL detection voltage $V_{OCL}$ pulses reaches the maximum value 'nUP'. When counting the number of OCL detection voltage $V_{OCL}$ pulses using a 4-bit counter, the maximum value 'nUP' may be 16 (=$2^4$). If the number of OCL detection voltage $V_{OCL}$ pulses reaches the maximum value 'nUP' ('Yes' direction), the process moves to operation S152. On the other hand, if the number of OCL detection voltage $V_{OCL}$ pulses does not reach the maximum value 'nUP' (direction 'No'), the process returns to operation S120.

In operation S152, the up-and-down counter 1350 of the adaptive OCL controller 1300 is counted up.

In operation S154, when the up-and-down counter 1350 of the adaptive OCL controller 1300 counts up, the up-and-down counter 1350 increases the size of the OCL control current $I_{OCL}$ of the variable current source 1360.

In operation S156, the OCL pulse counter is reset and the procedure returns to operation S120.

In operation S160, since the magnitude of the inductor current $I_{IND}$ does not reach the OCL level, a reset voltage $V_{RST}$ pulse is generated by the control loop circuit 1100. The reset voltage $V_{RST}$ of the control loop circuit 1100 is generated according to a comparison result between the error voltage $V_{ERR}$ and the ramp voltage $V_{RMP}$. That is, whenever the ramp voltage $V_{RMP}$ reaches the error voltage $V_{ERR}$, a reset voltage $V_{RST}$ pulse is generated.

In operation S170, it is checked whether reset voltage $V_{RST}$ pulses are continuously generated. If the reset voltage $V_{RST}$ pulses are continuously generated ('Yes' direction), the process moves to operation S175. On the other hand, if the reset voltage $V_{RST}$ pulses are not continuously generated ('No' direction), the process returns to operation S120.

In operation S175, the number of consecutive reset voltage $V_{RST}$ pulses is counted. For example, a 4-bit counter may be used as a means to count the number of reset voltage $V_{RST}$ pulses.

In operation S180, it is checked whether the number of consecutive reset voltage $V_{RST}$ pulses reaches the maximum value 'nDN'. When counting the number of reset voltage $V_{RST}$ pulses using a 4-bit counter, the maximum value 'nDN' may be 16 ($=2^4$). If the number of reset voltage $V_{RST}$ pulses reaches the maximum value 'nDN' ('Yes' direction), the process moves to operation S182. On the other hand, if the number of reset voltage $V_{RST}$ pulses does not reach the maximum value 'nDN' (direction 'No'), the process returns to operation S120.

In operation S182, the up-and-down counter 1350 of the adaptive OCL controller 1300 is counted down.

In operation S184, when the up-and-down counter 1350 of the adaptive OCL controller 1300 counts down, the up-and-down counter 1350 reduces the size of the OCL control current $I_{OCL}$ of the variable current source 1360.

At operation S186, the reset voltage pulse counter is reset and the procedure returns to operation S120.

In the above, the process of increasing or decreasing the OCL control current $I_{OCL}$ by counting the number of reset voltage $V_{RST}$ and OCL detection voltage $V_{OCL}$ pulses of the adaptive OCL controller 1300 has been described. The oscillator 1400 may generate an oscillation voltage Vosc having a variable switching frequency fsw according to the increasing or decreasing OCL control current $I_{OCL}$.

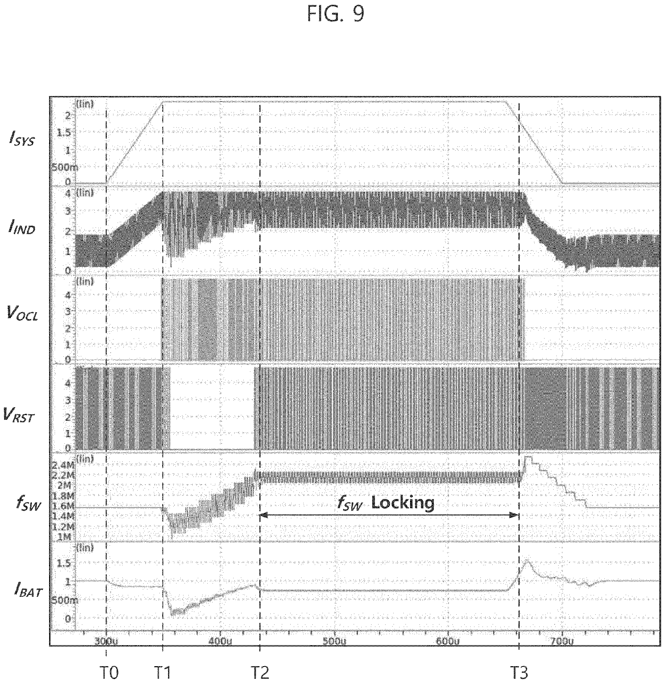

FIG. 9 illustrates the effect of the present disclosure. In FIG. 9, the battery charger IC 1000 may increase the switching frequency fsw of the inductor current $I_{IND}$ when the load current $I_{SYS}$ increases. As the switching frequency $f_{SW}$ increases, the magnitude of the average inductor current $I_{IND}$ can be increased, so the amount of energy delivered to the load can be increased.

At time T0, the load current $I_{SYS}$ required by the system of the mobile device 100 (see FIG. 1) rises. As the load current $I_{SYS}$ increases, the inductor current $I_{IND}$ supplied through switching also increases. However, the reset voltage $V_{RST}$ of the control loop circuit 1100 (see FIG. 2) is generated until the level of the inductor current $I_{IND}$ reaches the OCL level. That is, whenever the ramp voltage $V_{RMP}$ reaches the error voltage $V_{ERR}$ in the control loop circuit 1100, a reset voltage $V_{RST}$ pulse is generated.

From the time point T1, the level of the inductor current $I_{IND}$ starts to reach the OCL level. Then, the error voltage $V_{ERR}$ in the control loop circuit 1100 increases. The reset voltage $V_{RST}$ of the control loop circuit 1100 is generated according to a comparison result between the error voltage $V_{ERR}$ and the ramp voltage $V_{RMP}$. As the error voltage $V_{ERR}$ becomes higher than the ramp voltage $V_{RMP}$, generation of the reset voltage $V_{RST}$ is stopped. Instead, the OCL detection voltage $V_{OCL}$ pulse generated when the magnitude of the inductor current IIND reaches the OCL level in the OCL detector (1200, see FIG. 2) starts to be generated.

And, the number of OCL detection voltage $V_{OCL}$ pulses continuously occurring will be accumulated and counted by the adaptive OCL controller (1300, see FIG. 2). As the number of continuously occurring OCL detection voltage $V_{OCL}$ pulses is counted, the magnitude of the OCL control current $I_{OCL}$ starts to increase. Then, the switching frequency $f_{SW}$, which is the frequency of the oscillation voltage Vosc generated by the oscillator 1400 (see FIG. 2), increases up to the time point T2. At this time, as the switching frequency fsw increases, the level of the charging current $I_{BAT}$ input to the battery 1900 (see FIG. 2) will also begin to gradually recover.

At time T2, the error voltage $V_{ERR}$ starts to decrease again as the switching frequency $f_{SW}$ increases. Generation of the reset voltage $V_{RST}$ starts again by the lowered error voltage $V_{ERR}$. That is, from the time T2, the OCL detection voltage $V_{OCL}$ and the reset voltage $V_{RST}$ are alternately generated. That is, neither the OCL detection voltage $V_{OCL}$ pulse nor the reset voltage $V_{RST}$ pulse is continuously generated. Accordingly, as the magnitude of the OCL control current $I_{OCL}$ is fixed, locking of the switching frequency fsw occurs from time T2 to time T3 as a result. In addition, the magnitude of the charging current $I_{BAT}$ is also restored to a level similar to that before the rise of the load current $I_{SYS}$.

At time T3, a generation of the OCL detection voltage $V_{OCL}$ pulse stops as the load current $I_{SYS}$ decreases, and only the reset voltage $V_{RST}$ pulse is generated. Then, as the count number of reset voltage $V_{RST}$ pulses increases, the magnitude of the OCL control current $I_{OCL}$ decreases. As a result, the switching frequency fsw of the inductor current $I_{IND}$ will start to decrease from the time point T3.

Because the switching frequency fsw of the inductor current $I_{IND}$ can be increased as the load current $I_{SYS}$ increases, the size of the average inductor current that is switched can be increased. Accordingly, the battery charger IC 1000 of the present disclosure can deliver a lot of energy to the load despite the overcurrent limit for protection.

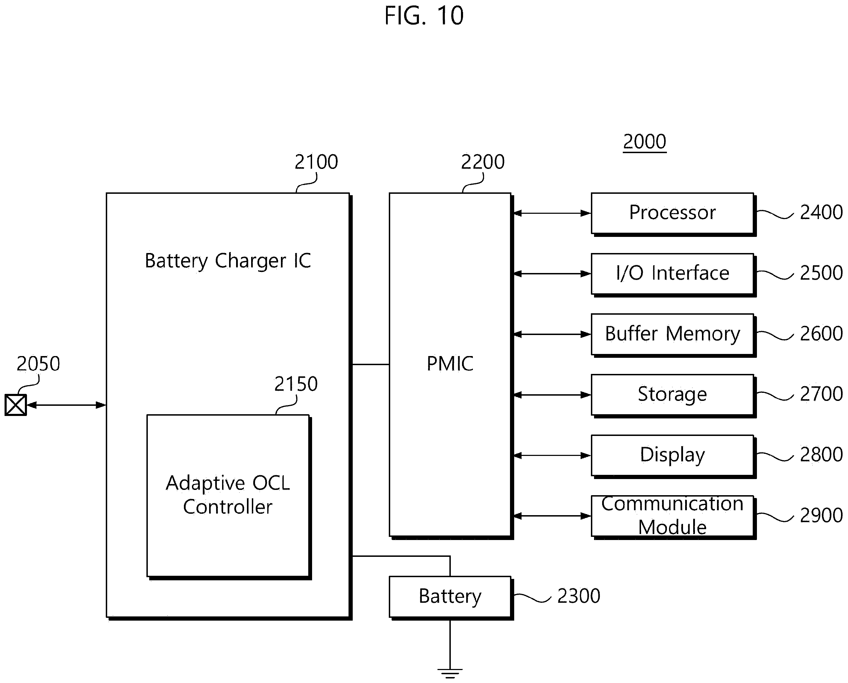

FIG. 10 illustrates a power system of a mobile device according to an embodiment of the present disclosure. In FIG. 10, a power system 2000 may include a battery charger IC 2100, a power management IC 2200, and a battery 2300. The power system 2000 shown in FIG. 10 may further include other components.

The power system 2000 may be used to supply power to a mobile device or to supply power to an OTG device. In the power system 2000, when a travel adapter is connected to the charging terminal 2050, the battery charger IC 2100 operates in a buck mode. That is, in the buck mode, the battery charger IC 2100 operates in a buck converter or charger mode in which the battery 2300 is charged by switching power provided through the travel adapter.

On the other hand, when an OTG device is connected to the charging terminal 2050, the battery charger IC 2100 operates in a boost mode or OTG mode. That is, in the boost mode, the battery charger IC 2100 may switch power charged in the battery 2300 to provide the boosted voltage to the OTG device. Configuration and operations of the battery charger IC 2100 according to an embodiment of the present disclosure may operate as described in FIGS. 1 to 9.

The power management IC 2200 may receive power from the battery charger IC 2100. For example, the power management IC 2200 may convert a voltage provided from the battery charger IC 2100 into a stable voltage. The power management IC 2200 may provide a stable voltage to other components of the mobile electronic device. Each of the processor 2400, the input/output interface 2500, the buffer memory 2600, the storage 2700, the display 2800, and the communication module 2900 included in the mobile electronic device are supplied from the power management IC 2200. It can operate using a stable voltage.

As an example, each of the battery charger IC 2100 or the power management IC 2200 may be implemented as an integrated circuit chip. Each of the battery charger IC 2100 or the power management IC 2200 may be mounted using various types of semiconductor packages. As an example, the battery charger IC 2100 or the power management IC 2200 may include Package on Package (PoP), Ball Grid Arrays (BGAs), Chip Scale Packages (CSPs), Plastic Leaded Chip Carrier (PLCC), and Plastic Leaded Chip Carrier (PDIP). Dual In-line Package), Die in Waffle Pack, Die in Wafer Form, Chip On Board (COB), Ceramic Dual In-line Package (CERDIP), Metric Quad Flat Pack (MQFP), Thin Quad Flat Pack (TQFP), Small Outline Integrated Circuit (SOIC), Shrink Small Outline Package (SSOP), Thin Small Outline Package(TSOP), System In Package (SIP), Multi Chip Package( MCP), Wafer-level Fabricated Package(WFP), Wafer-Level Processed Stack Package (WSP).

The above are specific embodiments for carrying out the present disclosure. In addition to the above-described embodiments, the present disclosure may include simple design changes or easily changeable embodiments. In addition, the present disclosure will include techniques that can be easily modified and implemented using the embodiments. Therefore, the scope of the present disclosure should not be limited to the above-described embodiments, and should be defined by the claims.

## Claims

1. A battery charger integrated circuit for charging a battery, comprising:

   an overcurrent limiting detector configured to detect whether a level of an inductor current reaches an overcurrent limiting level and to generate an overcurrent limiting detection voltage;
   a control loop circuit configured to generate a reset voltage by comparing a ramp voltage reflecting the level of the inductor current with an error voltage generated based on an operating condition that is out of a preset operating condition;
   an adaptive overcurrent limiting controller configured to generate an overcurrent limiting control current by counting a number of pulses of the overcurrent limiting detection voltage and a number of pulses of the reset voltage;
   an oscillator configured to generate an oscillation voltage wherein a frequency of the oscillation voltage varies based on a magnitude of the overcurrent limit control current; and
   a switching transistor for switching the inductor current based on the oscillation voltage.

2. The battery charger integrated circuit of claim 1, wherein the control loop circuit comprises:

   at least one compensator configured to generate an error voltage in a buck mode or a boost mode; and
   a ramp generator configured to generate a ramp voltage to which the level of the inductor current is applied.

3. The battery charger integrated circuit of claim 2, wherein the control loop circuit comprises:
a comparator configured to generate the reset voltage based on a level of the ramp voltage that reaches the error voltage.

4. The battery charger integrated circuit of claim 1, 2, or 3, wherein the adaptive overcurrent limiting controller comprises:

a first counter configured to count a number of continuously occurring pulses of the overcurrent limit detection voltage;
a first flip-flop configured to generate an up voltage based on a count value of the first counter, which reaches a threshold value;
a second counter configured to count the number of pulses of the reset voltage continuously occurring;
a second flip-flop configured to generate a down voltage based on a count value of the second counter, which reaches the threshold value; and
an up-and-down counter configured to count up in response to the up voltage and counting down in response to the down voltage.

5. The battery charger integrated circuit of claim 4, wherein the adaptive overcurrent limiting controller comprises:
a variable current source configured to generate the overcurrent limiting control current that is variable based on the count value of the up-and-down counter.

6. The battery charger integrated circuit of any one of claims 1 to 5, wherein the oscillator comprises:

an oscillation capacitor configured to charge the overcurrent limit control current;
an oscillation current source configured to generate an oscillation current and configured to supply the oscillation current to the oscillation capacitor; and
a comparator configured to generate the oscillation voltage by comparing a sawtooth waveform voltage formed in the oscillation capacitor with an oscillation reference voltage.

7. The battery charger integrated circuit of claim 6, wherein the oscillator comprises:

a discharge switch configured to discharge the current charged in the oscillation capacitor to ground; and
a delay unit configured to delay the oscillation voltage output from the comparator to drive the discharge switch.

8. The battery charger integrated circuit of any one of claims 1 to 7, further comprising:

an OR gate configured to perform a logical sum operation of the reset voltage and the overcurrent limit detection voltage; and
an SR latch configured to receive the oscillation voltage through a set input terminal, to receive a result of an OR operation of the OR gate through a reset input terminal, and to generate a duty voltage for driving the switching transistor.

9. An electronic device comprising:

an inductor supplying a charging current supplied from a charging terminal to a battery and a load;
switching transistors configured to switch the inductor current flowing through the inductor based on a duty voltage and configured to transfer the inductor current as a battery current for charging the battery or a load current supplied to the load; and
a battery charger integrated circuit as claimed in any one of claims 1 to 8 and configured to monitor a change in the load current and varying a switching frequency of the inductor current, wherein the battery charger integrated circuit is configured to increase the switching frequency by counting a number of times that a level of the inductor current reaches an overcurrent limit level.

10. The electronic device of claim 9, wherein the battery charger integrated circuit is further configured to increase the level of the inductor current by varying a duty cycle of the duty voltage based on an increase in the load current.

11. The electronic device of claim 9 or 10, wherein the battery charger integrated circuit comprises:

an overcurrent limiting detector configured to detect whether the level of the inductor current reaches the overcurrent limiting level and configured to generate an overcurrent limiting detection voltage;
a control loop circuit configured to generate a reset voltage for varying a duty ratio of the duty voltage by comparing a ramp voltage reflecting the level of the inductor current with an error voltage generated based on an operating condition that is out of a preset operating condition;
an adaptive overcurrent limiting controller configured to generate an overcurrent limiting control current by counting a number of pulses of the overcurrent limiting detection voltage and a number of pulses of the reset voltage; and an oscillator configured to generate an oscillator voltage wherein a frequency of the oscillator voltage varies based on a magnitude of the overcurrent limit control current.

12. A method performed by a battery charger integrated circuit, the method comprising:

detecting an increase in a load current;
increasing a duty cycle of a duty voltage for switching an inductor current in response to detecting the increase in the load current;
detecting whether a level of the inductor current reaches a predetermined overcurrent limit level; and
increasing a switching frequency of the duty voltage based on a number of consecutively reaching the predetermined overcurrent limit level of the inductor current, which reaches a predetermined reference number of times.

13. The method of claim 12, further comprising:

generating a reset voltage by comparing a ramp voltage reflecting the level of the inductor current with an error voltage generated based on an operating condition that is out of a preset operating condition, under the increased switching frequency condition.

14. The method of claim 13, further comprising fixing a switching frequency of the duty voltage based on the reset voltage that is generated.

15. The method of claim 13 or 14, further comprising reducing the switching frequency based on the number of consecutive occurrences of the reset voltage, which reaches a predetermined number of times.

FIG. 1

FIG. 2

FIG. 3

FIG. 4

1200

1220

$V_{OCL, REF}$ ——○— [−]

$V_{LSEN}$ ——○— [+] ——○——→ $V_{OCL}$

FIG. 5

EP 4 362 270 A1

FIG. 6

EP 4 362 270 A1

FIG. 7

EP 4 362 270 A1

## FIG. 8

Detect inductor current $I_{IND}$ —S110

$I_{IND}$ Peak > OCL level ? — S120

Yes → Generate $V_{OCL}$ pulse —S130

No → Generate $V_{RST}$ pulse —S160

Successive $V_{OCL}$ pulse ? — S140

No →

Yes → Count up $V_{OCL}$ pulse —S145

Number of $V_{OCL}$ pulse = nUP? — S150

No →

Yes → Count up UP/DN counter —S152

Reset $V_{OCL}$ counter —S156

Increase $I_{OCL}$ —S154

Successive $V_{RST}$ pulse ? — S170

No →

Yes → Count up $V_{RST}$ pulse —S175

Number of $V_{RST}$ pulse = nDN? — S180

No →

Yes → Count Down UP/DN counter —S182

Reset $V_{OCL}$ counter —S186

Decrease $I_{OCL}$ —S184

FIG. 9

EP 4 362 270 A1

# FIG. 10

EP 4 362 270 A1

Europäisches
Patentamt

European
Patent Office

Office européen
des brevets

**EUROPEAN SEARCH REPORT**

Application Number

**EP 23 18 8552**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 7 091431 B2 (ROHM CO LTD) 27 June 2022 (2022-06-27) * figures 1,6 * | 1-15 | INV. H02J7/00 |
| A | KR 2020 0125006 A (SAMSUNG ELECTRONICS CO LTD [KR]) 4 November 2020 (2020-11-04) * figure 2 * | 1-15 | |
| A | US 9 246 348 B2 (SOLIE ERIC M [US]; INTERSIL AMERICAS LLC [US]) 26 January 2016 (2016-01-26) * figures 1-2 * | 1-15 | |
| A | US 2012/049829 A1 (MURAKAMI KAZUHIRO [JP]) 1 March 2012 (2012-03-01) * figure 1 * | 1-15 | |

TECHNICAL FIELDS
SEARCHED (IPC)

H02J

The present search report has been drawn up for all claims

| Place of search | Date of completion of the search | Examiner |
|---|---|---|
| Munich | 15 March 2024 | Bourdon, Jérémy |

EPO FORM 1503 03.82 (P04C01)

**EP 4 362 270 A1**

## ANNEX TO THE EUROPEAN SEARCH REPORT
## ON EUROPEAN PATENT APPLICATION NO.

EP 23 18 8552

This annex lists the patent family members relating to the patent documents cited in the above-mentioned European search report.
The members are as contained in the European Patent Office EDP file on
The European Patent Office is in no way liable for these particulars which are merely given for the purpose of information.

15-03-2024

| Patent document cited in search report | | Publication date | Patent family member(s) | | Publication date |
|---|---|---|---|---|---|
| JP 7091431 | B2 | 27-06-2022 | JP | 6815127 B2 | 20-01-2021 |
| | | | JP | 7091431 B2 | 27-06-2022 |
| | | | JP | 2017060383 A | 23-03-2017 |
| | | | JP | 2021045046 A | 18-03-2021 |
| KR 20200125006 | A | 04-11-2020 | CN | 111865070 A | 30-10-2020 |
| | | | KR | 20200125006 A | 04-11-2020 |
| | | | US | 2020343815 A1 | 29-10-2020 |
| | | | US | 2021159793 A1 | 27-05-2021 |
| US 9246348 | B2 | 26-01-2016 | NONE | | |
| US 2012049829 | A1 | 01-03-2012 | CN | 202818097 U | 20-03-2013 |
| | | | JP | WO2010134516 A1 | 12-11-2012 |
| | | | US | 2012049829 A1 | 01-03-2012 |
| | | | WO | 2010134516 A1 | 25-11-2010 |

EPO FORM P0459

For more details about this annex : see Official Journal of the European Patent Office, No. 12/82